# EUROPEAN PATENT SPECIFICATION

(11) **EP 0 515 329 B1**
(45) Date of publication and mention of the grant of the patent: **18.10.1995**
(21) Application number: 92830240.5
(22) Date of filing: 20.05.1992
(51) Int. Cl.: H05K 7/20

(54) **Self-contained, transportable apparatus provided with ventilating and air conditioning systems which guarantees the continuous power supply to one or more users**
Bewegbare, selbständige Vorrichtung, welche mit Lüftungs- und Luftkonditioniersystemen ausgerüstet ist und welche eine ununterbrochene Energieversorgung an einen oder mehrere Anwender gewährleistet
Appareil autonome et transportable muni des systèmes à ventilation et à conditionnement de l'air assurant l'alimentation continuelle d'énergie à un ou plusieurs utilisateurs

(30) Priority: 22.05.1991 IT RM910349
(43) Date of publication of application: 25.11.1992
(73) Proprietor: Bethlen de Bethlen, Miklos Istvan, I-00135 Roma (IT)
(72) Inventor: Bethlen de Bethlen, Miklos Istvan, I-00135 Roma (IT)
(74) Representative: Sarpi, Maurizio

(56) References cited:
- EP-A- 0 272 961
- EP-A- 0 356 991
- GB-A- 2 117 981
- US-A- 4 661 734
- US-A- 4 691 274

## Description

This invention relates to a self-contained apparatus for the continuous power supply of one or more users which features small overall dimensions, fast installation, and effective soundproofing, and includes in combination an inverter, a generating set, an accumulator battery with relative buffer control and recharge unit, and a ventilating and air conditioning system.

The described apparatus appears in the form of a self-supporting container or shelter of restricted dimensions which can then be easily transported and located both inside and outside the facilities to which it is to be connected.

With the increasing utilization of electronics in a number of productive activities the need to guarantee a steady power supply even during a circuit transient, microbreak, power failure or blackout is of primary importance.

At present this is done by placing a number of single commercially available apparatus such as an inverter, a generating set, and an accumulator battery provided with control and recharge unit in parallel between mains and user. However, the installation of such apparatus has a number of drawbacks: the different units have to be assembled by hand; once such units have been assembled, they cannot be moved without dismantling them; in addition, they are cumbersome and noisy making it difficult to assemble them inside a building.

From US-A- 4691274 there is further known a modular electronic power supply, which, with the use of optional batteries attached to the same, can function as an uninterruptible power system (UPS). This electronic power supply comprises a framework having front and rear sides and top and bottom sides and having a vertically disposed space extending upwardly from the bottom of the framework through the top of the framework. It also is comprised of a plurality of power modules disposed in the framework and having heat sinks extending into the vertically disposed space. Fans are provided for forcing air in a vertical direction through the space.

In Italian Patent No. 1208678 of the same Applicant, an apparatus for continuously supplying power has been disclosed in which all of the above mentioned units are placed within one compact, transportable, heat insulated, soundproof container or shelter. In order to keep the inner temperature under control the use of a ventilating and air conditioning system is provided.

Despite the obvious advantages of such an apparatus, its usage has displayed a number of limitations.

First of all, the use of air from outside for properly ventilating the uninterruptible power system (UPS) proved impossible as the sophisticated electronics of the latter suffer the presence of any dust entrained by the air.

In addition, the ventilating and air conditioning system requires excessive energy and space.

The present invention seeks to avoid the above mentioned drawbacks by improving the efficiency of the ventilating and air conditioning system, reducing the overall dimensions, and assuring to the UPS a proper air circulating system which prevents outside dust from being let in.

This has been achieved by an apparatus as defined in claim 1.

Each subassembly of the apparatus (generating set, inverter, accumulator battery and control units) is set apart in a suitable compartment provided with an access door for correct inspection; such compartments are shut up in two warm and cold sides of the shelter, completely separated from each other;
each fan of the engine and the alternator is used for independently intaking air from the outside through separate inlets for cooling its relative subassembly. In particular, the fan of the engine has the function of air-cooling the parts of the diesel engine, while the fan of the alternator cools the alternator. The cooling air of the diesel engine intaken from the outside through labyrinth channels laps the alternator and is conveyed into an outlet labyrinth of the shelter. The alternator receives fresh air from the outside through a feed channel and expels warm air to the main current of the cooling air of the engine;
in the compartment of the UPS the heat produced by the inverter is exhausted by an intake fan of warm air which lets air into a closed-circuit ventilating system without connection to the outside. The heat is used for heating a gas in a condenser which is then compressed to be conveyed to a heat exchanger or evaporator where it expands according to an adiabatic process expelling heat to the outside through another fan.

Further features and advantages of the invention will be more readily apparent from the following description with reference to the accompanying drawings which illustrate a non-limitative example of a preferred embodiment of the invention.

In the drawings:
Fig. 1 is a perspective view of the front side of the apparatus in a closed container or shelter;
Fig. 2 is a perspective view of the rear side of the same;
Fig. 3 is a block diagram of the apparatus;
Fig. 4 is a diagram of the ventilation air flows of the apparatus on the engine-alternator side;
Fig. 5 is a diagram of the air flows of the air conditioning system of the uninterruptible power system;
Fig. 6 shows the inner compartments of the front side of the shelter;
Fig. 7 shows the inner compartments of the rear side of the same.

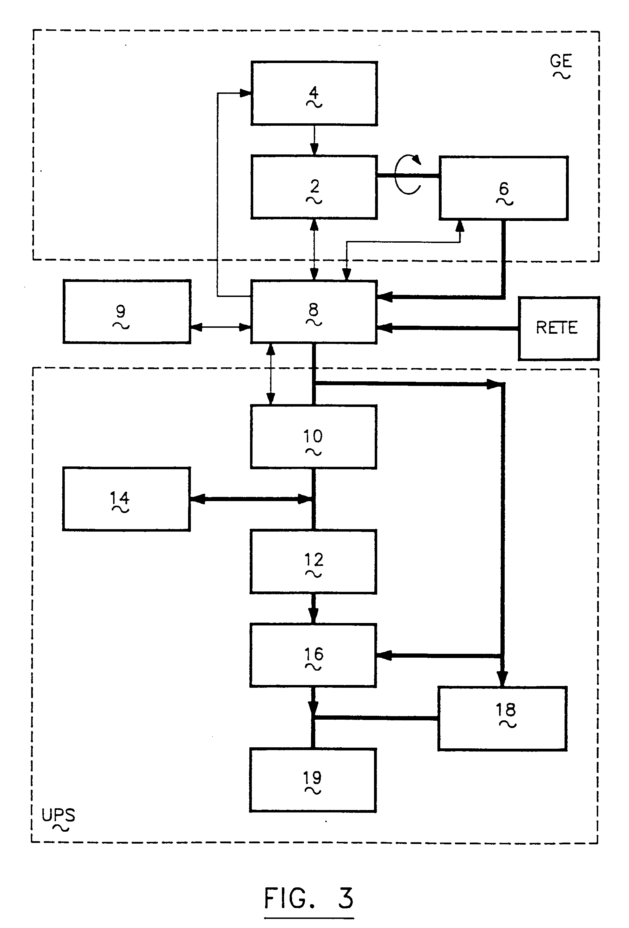

With reference to Figs. 3, 6 and 7 the apparatus according to the invention includes: a generating set (block GE) comprising an engine 2, its starter battery 4, and an alternator 6; an uninterruptible power system, generally known as UPS, comprising a rectifier 10, a static inverter 12, a static switch 16, and a manual bypass 18; an accumulator battery 14 for buffer purposes, and a control panel 8 also containing the logic circuits of the UPS and the generating set GE.

A possible remote control unit for controlling the apparatus is indicated at 9.

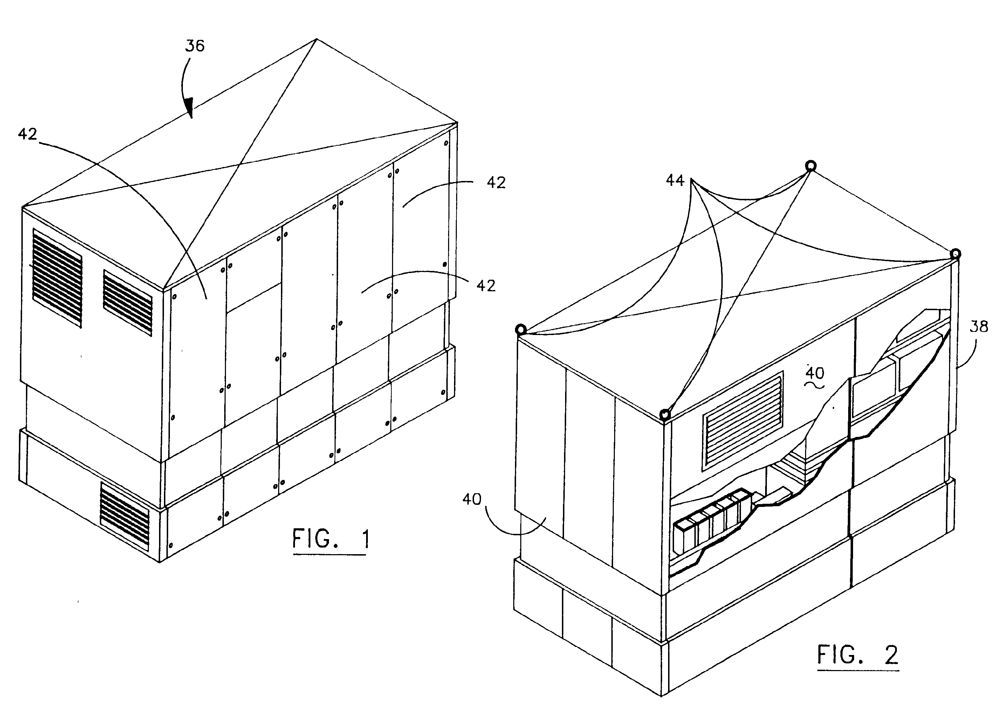

The assembly of such components is contained in a box-like construction 36 (Fig. 1) formed of a strong self-supporting frame 38 which is closed by outer panels 40, secured so as to be removable, and doors 42 that can be opened from the outside. The self-supporting frame is provided with eyebolts 44 for lifting purposes.

The described apparatus assures a continuous power supply as follows: Under normal operating conditions load 19 is supplied by the mains through rectifier 10 and inverter 12. Rectifier 10 is intended to provide both the power necessary to the inverter and the automatic charge of the accumulator battery 14.

In case of power failure the buffer accumulator battery 14 operates instantaneously (zero time) so as to assure the absolute continuity of the supply, and the logic of control panel 8 operates the generating set which, under steady conditions, takes on the load through rectifier 10 and inverter 12.

When the power comes back the apparatus switches off to return to the mains operation.

The generating set checks through control panel 8 that the mains is supplying power, whereupon it switches off, assigning the load to the mains and restoring the original operating conditions without any power break. The rectifier automatically recharges the accumulator battery and at the same time supplies the inverter.

If the inverter breaks down or when the input voltage of the inverter is beyond the predetermined limits, the power supply of the user is instantaneously transferred through the static bypass switch to the safety network which assures the continuity of the power supply.

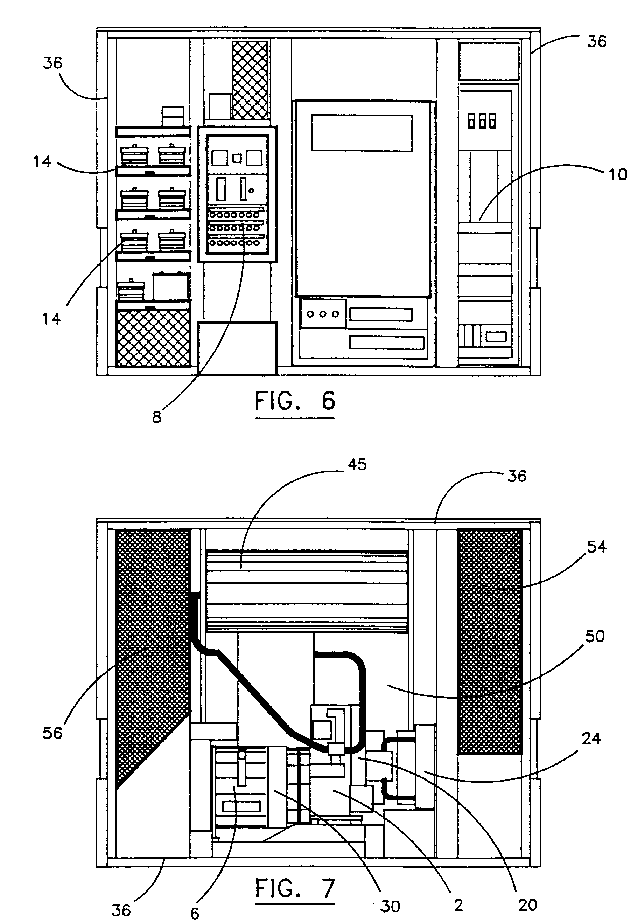

As can be seen in Figs. 6 and 7 the assembly which includes inverter and rectifier, the accumulator battery and the control panel, are located within the shelter in separated compartments accessible from the front side (cold side) through doors. The generating set is located at the rear side within a compartment which also contains a large catalytic muffler 45 for the treatment of the exhaust gases of the diesel engine.

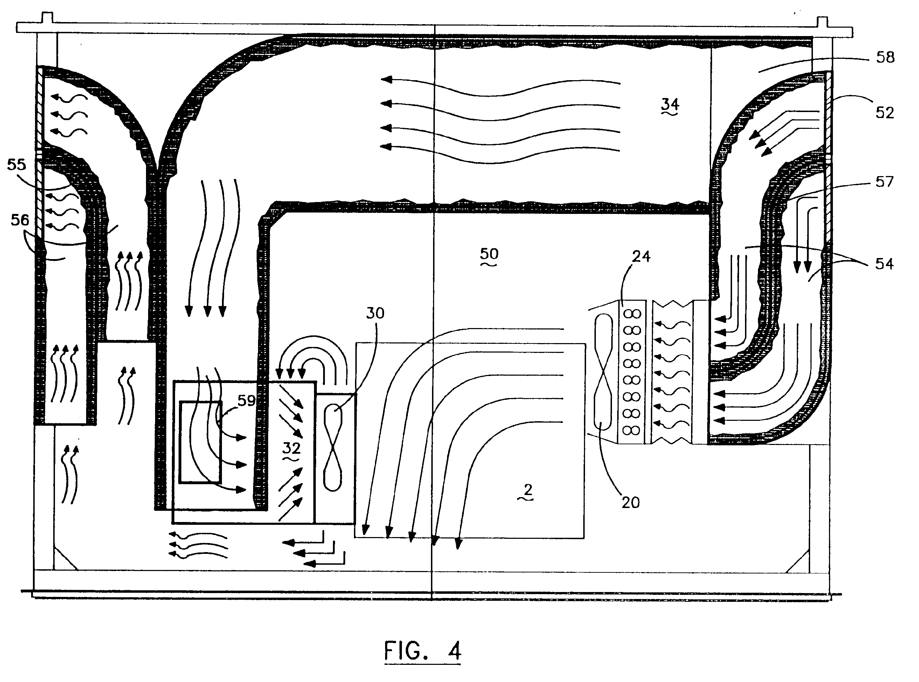

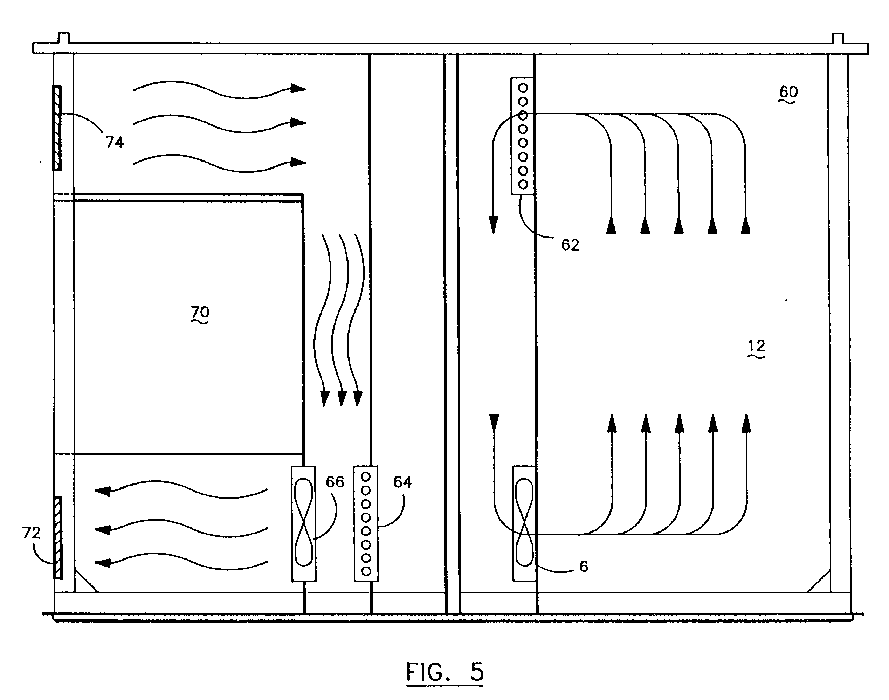

The operation of inverter 12, engine 2 and alternator 6 involves the dissipation of a part of the produced energy into heat. In order to convey such heat to the outside the present invention resorts to the system illustrated in Figs. 4 and 5.

Engine 2, mounted in compartment 50 of the container or shelter, is cooled by an air current produced by fan 20 splined to the drive shaft 22. The air enters from air grating 52, is conveyed to the intake conduit 54, and crosses first water radiator 24, then the whole engine compartment 50 before being expelled into the atmosphere through conduit 56. Both intake conduit 54 and exhaust conduit 56 are soundproofed by a lining of foamed polyurethane and are internally separated by a partition 57, 55 which reduces the flow rate of the air current and improves the noise suppression. The length of the acoustic trap is sufficient to assure an acceptable noise level.

A fan 30 is splined to the shaft of alternator 6 and, besides causing air to circulate in engine compartment 50, takes air in from port 59 of another conduit 34 leading to an air grating 58 adjacent to air grating 52 already mentioned. Since port 59 opens near the alternator casing, the latter is in any case crossed by a current of fresh air which will always be at a lower temperature than that of engine compartment 50.

The fans of the engine and the alternator operate to keep the temperature of the warm side (rear side) of the shelter substantially constant, while inverter, rectifier, voltage control logic, control panel and accumulator battery are located in the cold side in three adjacent compartments which are thermally insulated from rear compartment 50 and are provided with their own ventilating and air conditioning system using quite independent air currents in order to avoid that the air circulating in the inverter compartment exceeds the temperature of 35-40°C and has a detrimental effect on the operation and the reliability. The system is shown in Fig. 5.

As seen in this figure, the air current produced by fan 61 within compartment 60 transmits heat to condenser 62 of a heat pump after having blown on inverter 12 and is recycled to the fan along a closed circuit without mixing in air from the outside. This allows any dust to be limited in the compartment of the inverter in order not to have a detrimental effect on the operation of the same. The heat transferred to condenser 62 liquefies the gas circulating in the latter which is subjected to an adiabatic compression and is fed through pipes (not shown) to evaporator 64 where it expands adiabatically transferring heat to the outside by an intake fan 66. Besides removing heat produced by evaporator 64, fan 66 takes in fresh air from the outside through port 74, thus assuring the ventilation of compartment 70 where the buffer accumulator battery and control panel 8 are located. On the other side, the cooled, expanded gas returns to condenser 62 and cools air circulating in the compartment of the UPS.

From the foregoing, the advantages of the apparatus according to the invention are self-evident:
- the subassemblies are contained in a shelter of reduced overall dimensions which can be immediately installed both inside and outside the user's facilities to which it is to be connected;
- the temperature of the different compartments, as well as the noise level during the operation, is kept under acceptable limits in a fully reliable and economical way;
- the closed-circuit air circulation in the compartment of the inverter assures operation under any environmental conditions.

## Claims

1. A self-contained, compact, transportable apparatus for the continuous power supply of one or more users, the apparatus consisting of a shelter (36) having a self supporting structure, the shelter including in combination a generating set (GE), an inverter (12), an accumulator battery (14) and a control unit (8) monitoring the continuity of the power supply, all located in suitable compartments accessible from two opposite sides of the self-supporting structure of the shelter, said opposite sides being separated by a partition in a warm side and a cold side, a ventilating system being provided in the warm side using fans (20, 30) splined respectively to the drive shaft of the engine (2) and to the shaft of the alternator (6) of the generating set for producing two air currents which are independently intaken from the outside and separately conveyed to the inside for cooling the diesel engine (2) and the alternator (6), respectively; a self-contained cooling system being provided in the cold side maintaining the temperature of the inverter and the voltage control unit (8) under 40°C.

2. The apparatus for the continuous power supply of one or more users as claimed in claim 1, characterized in that, in order to avoid that the inverter comes into contact with fine dust entrained by atmospheric air, the cooling system is provided with an intake fan (61) which causes the warm air of the inverter compartment (60) to circulate along a closed circuit so that said warm air transmits heat to a condenser (62) in which a freezing fluid flows.

3. The apparatus for the continuous power supply of one or more users as claimed in any preceding claim, characterized in that the freezing fluid heated in the condenser is compressed and conveyed to an evaporator (64) placed in the adjacent compartment of the cold side where it is subjected to an adiabatic expansion transferring heat to the outside of the shelter through a fan (66) located in the same compartment.

4. The apparatus for the continuous power supply of one or more users as claimed in any preceding claim, characterized in that the exhaust gases of the diesel engine are conveyed to a catalytic muffler (45) placed in the same compartment and provided with an exhaust to the outside.

5. The apparatus for the continuous power supply of one or more users as claimed in any preceding claim, characterized in that the conduits (54, 56) in which the ventilation air of the warm side is conveyed are provided with sound traps for soundproofing.

## Patentansprüche

1. Transportable selbständige kompakte Vorrichtung zur ununterbrochenen Energieversorgung eines oder mehrerer Anwender mit einem Gehäuse bzw. Aufnahmeraum (36) in selbsttragender Bauweise, der in Kombination einen Generatorblock (GE) oder Generatorsatz, einen Wechselrichter bzw. Inverter (12), einen Akkumulator bzw. eine Batterie (14) und eine Steuereinheit (8) aufweist, welche das Bestehen der Energieversorgung anzeigt, bei der sich alle dies Aggregate in geeigneten Abteilen befinden, die von zwei entgegengesetzten Seiten der selbsttragenden Gehäusestruktur aus zugänglich sind, bei der diese entgegengesetzten Seiten durch eine Trennwand in einen warmen Teil und in einen kalten Teil getrennt sind, bei der im warmen Teil ein Ventilationssystem mit Lüftern bzw. Ventilatoren (20, 30) angeordnet ist, die mit der Antriebswelle der Maschine (2) bzw. mit der Welle des Alternators bzw. Generators (6) des Generatorblocks (GE) verbunden ist, um zwei Luftströme zu erzeugen, die unabhängig voneinander von der Außenseite eintreten und getrennt zum Innenraum zum Rühlen der Maschine (2), insbesondere Dieselmaschine, bzw. des Generators (6) führen, und bei der ein selbständiges Kühlsystem im kalten Teil die Temperatur des Inverters (12) und der Spannungssteuereinheit (8) unter 40° C hält.

2. Vorrichtung nach Anspruch 1, dadurch gekennzeichnet,
daß das Kühlsystem mit einem Eingangsventilator (61) versehen ist, der das Zirkulieren von Warmluft des Inverterteils (60) längs eines geschlossenen Kreislaufs so bewirkt, daß Warmluftwärme zu einem Kondensator (62) gelangt, in dem Kühlmittel fließt, damit vermieden wird, daß der Inverter in Kontakt mit in der atmosphärischen Luft befindlichen feinen Staubteilchen gelangt.

3. Vorrichtung nach Anspruch 1 oder 2, dadurch gekennzeichnet,
daß das im Kondensator (62) erhitzte Kühlmittel unter Druck gesetzt und zu einem Verdampfer (64) befördert wird, der sich im Nachbarabteil im kalten Teil an der Stelle befindet, an der es einer adiabatischen Expansion ausgesetzt ist, wodurch Wärme mittels eines Lüfters bzw. Ventilators (66), der sich im gleichen Abteil befindet, zur Außenseite des Aufnahmeraums gelangt.

4. Vorrichtung nach einem der vorhergehenden Ansprüche, dadurch gekennzeichnet,
daß die von der Dieselmaschine stammenden Gase zu einem katalytischen Auspuff (45) bzw. Schalldämpfer gelangen, der sich im selben Abteil befindet und mit einem nach außen führenden Austritt versehen ist.

5. Vorrichtung nach einem der vorhergehenden Ansprüche, dadurch gekennzeichnet,
daß diejenigen Leitungen (54, 56), in denen Ventilationsluft des warmen Teils gefördert wird, zum Geräuschdämpfen mit einer geräuschdämpfenden Vorrichtung bzw. einem sound trap versehen sind.

## Revendications

1. Appareil autonome, compact et transportable destiné à assurer l'alimentation continue en courant d'un ou de plusieurs consommateurs, l'appareil étant constitué d'un abri (36) ayant une structure autoporteuse, l'abri incluant, en combinaison, un groupe électro-générateur (GE), un inverseur (12), une batterie d'accumulateur (14) et une unité de régulation (8) surveillant la continuité de l'alimentation en courant, tous ces éléments étant logés dans des compartiments appropriés accessibles de deux côtés opposés de la structure autoporteuse de l'abri, lesdits côtés opposés étant séparés l'un de l'autre par une division en un côté chaud et un côté froid, un système ventilateur étant prévu dans le côte chaud, utilisant des ventilateurs (20, 30) respectivement clavetés sur l'arbre d'entraînement du moteur (2) et sur l'arbre de l'alternateur (6) du groupe électro-générateur, de manière à produire deux flux d'air aspirés indépendamment à l'extérieur et acheminés séparément vers l'intérieur afin de refroidir respectivement le moteur diesel (2) et l'alternateur (6); un système de refroidissement autonome étant prévu du côté froid, maintenant la température des unités d'inverseur et de régulation de la tension (8) en dessous de 40 °C.

2. Appareil d'alimentation continue en courant pour un ou plusieurs consommateurs, selon la revendication 1, caractérisé en ce que, pour éviter que l'inverseur entre en contact avec des poussières fines véhiculées dans l'air atmosphérique, le système de refroidissement est pourvu d'un ventilateur d'admission (61), qui amène l'air chaud du compartiment d'inverseur (60) à circuler en un circuit fermé, de manière que ledit air chaud transmette la chaleur à un condenseur (62), dans lequel circule un fluide cryogénique.

3. Appareil d'alimentation continue en courant pour un ou plusieurs consommateurs, selon l'une quelconque des revendications précédentes, caractérisé en ce que le fluide cryogénique réchauffé dans le compartiment condenseur est comprimé et conduit dans un évaporateur (64) placé dans le compartiment adjacent du côté froid, où le fluide est soumis à une expansion adiabatique transférant la chaleur à l'extérieur de l'abri via un ventilateur (66) situé dans le même compartiment.

4. Appareil d'alimentation continue en courant pour un ou plusieurs consommateurs, selon l'une quelconque des revendications précédentes, caractérisé en ce que les gaz d'échappement du moteur diesel sont acheminés vers un silencieux catalytique (45) placé dans le même compartiment, et pourvu d'un échappement vers l'extérieur.

5. Appareil d'alimentation continue en courant pour un ou plusieurs consommateurs, selon l'une quelconque des revendications précédentes, caractérisé en ce que les conduits (54, 56), dans lesquels est acheminé l'air de ventilation du côté chaud, sont pourvus de pièges phoniques assurant une insonorisation.
